Europäisches Patentamt

European Patent Office

Office européen des brevets

(19)

(11) **EP 0 452 797 B1**

(12) **EUROPÄISCHE PATENTSCHRIFT**

(45) Veröffentlichungstag und Bekanntmachung des Hinweises auf die Patenterteilung:
**14.08.1996 Patentblatt 1996/33**

(51) Int Cl.$^6$: **H03H 17/02**, G01S 13/72

(21) Anmeldenummer: **91105720.6**

(22) Anmeldetag: **11.04.1991**

(54) **Kalman-Filter**

Kalman filter

Filtre de kalman

(84) Benannte Vertragsstaaten:
**BE DE ES FR GB IT NL**

(30) Priorität: **14.04.1990 DE 4012247**

(43) Veröffentlichungstag der Anmeldung:
**23.10.1991 Patentblatt 1991/43**

(73) Patentinhaber: **Daimler-Benz Aerospace Aktiengesellschaft**
**D-81663 München (DE)**

(72) Erfinder:
- **Seels, Werner, Dipl.-Math.**
  **W-7900 Ulm (DE)**
- **Robinson, David**
  **W-7900 Ulm-Böfingen (DE)**

(74) Vertreter: **Fröhling, Werner Otto, Dr. et al**
**Daimler-Benz Aerospace AG**
**Patentabteilung**
**Sedanstrasse 10**
**89077 Ulm (DE)**

(56) Entgegenhaltungen:
- **26TH IEEE CONFERENCE ON DECISION AND CONTROL Bd. 2, Nr. TP8, 11. Dezember 1987, LOS ANGELES, US Seiten 1476 - 1481; HASHEMI ET AL: 'Parallel Structures for Kalman Filtering'**
- **CONFERENCE PROCEEDINGS OF MILITARY ELECTRONICS DEFENCE EXPO. 1978 3. Oktober 1978, WEISBADEN, DE Seiten 414 - 432; FARUQI: 'The Target Tracking Problem Using Airborne RADAR under ECM'**

**Beschreibung**

Die Erfindung betrifft ein Kalman-Filter gemäß dem Oberbegriff des Patentanspruches 1. Aus dem Stand der Technik ist diesbezüglich beispielsweise eine Anordnung von A.P. Sage, J.L. Melsa: "Estimation Theory with Applications to Communications and Control", Mc Graw Hill Book Company, 1971, Seite 268 bekannt.

Die Erfindung der genannten Art wird unter anderem in Flugkörpern, Radaranlagen, Funkanlagen usw. eingesetzt und kommt daher beispielsweise im Bereich der Übertragungstechnik und Signalverarbeitung zur Anwendung.

Mit derartigen Anlagen ist es möglich, Ziele zu trakken (verfolgen), d.h. in Echtzeit die Bahndaten (z.B. Position und/oder Höhe, Geschindigkeitsbetrag und/oder -richtung, eventuell Beschleunigung nach Betrag und Richtung) von Zielen zu bestimmen, welche von einem oder mehreren Sensoren vermessen werden. Die von den Sensoren erzeugten Zielmeldungen sind Eingangsdaten einer sogenannten Tracking-Funktion.

Bei der Verfolgung eines Zieles ergeben sich im allgemeinen folgende störende Schwierigkeiten:

- Die Sensoren erfassen und/oder vermessen nicht alle gewünschten Bahndaten, sondern z.B. nur die Positionen der Ziele, möglicherweise zusätzlich deren Radialgeschwindigkeit.
- Die Zielvermessung erfolgt überwiegend in Polarkoordinaten.
- Häufig fehlt der Elevationswinkel, auch die Entfernung ist nicht immer meßbar.
- Messungen verschiedenen Typs treten gemischt auf, z.B.

    · Entfernung und Azimutwinkel und Elevationswinkel und Radialgeschwindigkeit
    · nur der Azimutwinkel
    · beliebige sonstige Kombinationen.

- Alle Meßwerte sind durch Meßfehler verfälscht.
- Verschiedene Sensoren haben unterschiedliche Meßfehlerstatistiken.

Die von diesen Sensoren erzeugten Meßdaten werden bei einem Tracking-Verfahren (Zielverfolgungsverfahren) derzeit vorzugsweise mit Hilfe eines Kalman-Filters verarbeitet, das durch folgende Regel darstellbar ist.

$$x_k^+ = x_k^- + K_k \cdot (Z_k - H_k \cdot x_k^-) \qquad (1.0)$$

mit

$$K_k = P_k^- \cdot H_k^T \cdot (H_k \cdot P_k^- \cdot H_k^T + R_k)^{-1} \qquad (1.10)$$

$$P_k^- = \phi_k \cdot P_{k-1}^+ \cdot \phi_k^T + G_k \cdot W_k \cdot G_k^T \qquad (1.11)$$

$$P_k^+ = (I - K_k \cdot H_k) \cdot P_k^- \qquad (1.12)$$

$$P_o^+ = P_o \qquad (1.13)$$

$$x_o^+ = \mu_o \qquad (1.20)$$

$$x_k^- = \phi_k \cdot \hat{x}_{k-1}^+ \qquad (1.21)$$

wobei

$$Z_k = H_k \cdot \hat{x}_k + v_k \qquad (1.30)$$

$$\hat{x}_k = \phi_k \cdot \hat{x}_{k-1} + G_k \cdot u_k \qquad (1.33)$$

und

$$E\{u_k\} = 0, \; E\{v_k\} = 0, \; E\{\hat{x}_o\} = \mu_o \qquad (1.40)$$

$$\text{cov}\{u_j, u_k\} = W_j \cdot \delta_K \,(j - k) \qquad (1.41)$$

$$\text{cov}\{v_j, v_k\} = R_j \cdot \delta_K \,(j - k) \qquad (1.42)$$

$$\text{cov}\{u_j, v_k\} = \text{cov}\{\hat{x}_o, u_k\} = 0 \qquad (1.43)$$

$$\text{cov}\{\hat{x}_o, v_k\} = 0 \qquad (1.44)$$

$$\text{var}\{\hat{x}_o\} = P_o \qquad (1.45)$$

hierbei bedeutet

$x_k^+$ gefilterter Zustandsvektor im realen System

$x_k^-$ vorhergesagter Zustandvektor im realen System

$K_k$ Kalman-Gewinn-Matrix

$Z_k$ Meßvektor

$H_k$ Meßmatrix

$P_k^-$ Kovarianzmatrix von $x_k^-$

$P_k^+$ Kovarianzmatrix von $x_k^+$

$R_k$ Kovarianz der Messung

$\phi_k$ Transitionsmatrix

$G_k$ Matrix, die die Einwirkung von uj auf den Zustand des Systemes beschreibt.

$W_k$ Kovarianzmatrix des Systemrauschens

$I$ Einheitsmatrix

$\hat{x}_k$ unbekannter wahrer Wert des Vorhersagezustandes

$P_o$ Anfangswert der Kovarianz von $\hat{x}$

$\mu_o$ konstanter Anfangszustand

$u_j$ Systemrauschen

$V_j$ Messfehler

$\delta_k$ (j-k) = { 0 für j ≠ k (Kronecker-Symbol)
{ 1 für j = k

Hochgestelltes T steht für transponiert.
E, cov, var steht in 1.40 bis 1.45 für Erwartungswert, Kovarianz, Varianz.

Diese allgemein formulierten Regeln müssen entsprechend der gestellten konkreten Tracking-Aufgabe für ein anwendbares Filter-Verfahren modifiziert werden. Dazu gehören

a. die Wahl des Koordinatensystems, in dem die Messungen $z_k$ beschrieben werden,
b. die Wahl des Koordinatensystems, in dem die System-Zustände $x_k$ beschrieben werden,
c. die Festlegung der Meßmatrix $H_k$, mit deren Hilfe vom Zustandsraum in den Meßraum transformiert wird, $H_k$ ergibt sich aus den Punkten a und b,
d. die Festlegung der Transitionsmatrix $\phi_k$, welche die Fortschreibung des Systemzustandes in der Zeit beschreibt. $\phi_k$ ergibt sich nach der Festlegung von Punkt b aus der Kinematik,
e. die Modifizierung des Systemrauschens ($u_k$, $W_j$, $G_k$), welches die bei der Festlegung von $\phi_k$ unvermeidlichen Restfehler beschreibt.

Die verwendeten Sensoren messen unabhängig voneinander jeweils eine oder mehrere der Komponenten

- Azimut-Winkel,
- Elevations-Winkel,
- Radialentfernung
- Radialgeschwindigkeit

Hierzu eignen sich Radarverfahren wie z.B. das Pulsdopplerverfahren. In einer Auswerteeinheit ist schaltungsmäßig ein Kalman-Filter ausgebildet.

Die für das Kalman-Filter erforderliche Beschreibung der Meßfehler-Statistik (Meßfehler-Kovarianz) erfordert dabei den geringsten Aufwand, wenn der Meßraum in sensor-zentrierten Polarkoordinaten beschrieben ist.

Für Mono-Sensor-Situationen werden deshalb gelegentlich Polarkoordinaten sowohl für den Meß- als auch den Zustandsraum verwendet. Dabei ist das Auftreten von Scheinbeschleunigungen von Nachteil, d.h. die Bahnbeschreibung eines unbeschleunigten Zieles ist, abgesehen von radial verlaufenden Bahnen, nur unter Zuhilfenahme von zweiten Zeitableitungen im Zustandsvektor möglich. Außerdem ist eine Anwendung auf Multi-Sensor-Situationen mit räumlich verteilten Sensoren nicht durchführbar. Um diese Schwierigkeiten zu umgehen, werden kartesische Koordinaten im Zustandsraum schaltungsmäßig definiert. Je nach spezieller Systemauslegung werden zwei oder drei Komponenten des Ortes benutzt, für jede Ortskomponente wird die erste und eventuell auch die zweite Ableitung nach der Zeit im Zustand stand mitverwendet. Ein solches System erfordert außer der Umrechnung der Meßvektoren in kartesische Koordinaten auch die entsprechende Umrechnung der Kovarianz-Matrizen. Eine solche Umrechnung ist in nachteiliger Weise kosten- und zeitaufwendig, insbesondere dann, wenn gleichzeitig eine Vielzahl von Zielen verfolgt werden muß, das heißt wenn eine hohe Lastzahl vorhanden ist.

Das Einbringen von Messungen, welche nicht eindeutig einen einzigen Punkt im Meßraum beschreiben, ist dabei nachteiligerweise nicht ohne weiteres möglich. So läßt sich z.B. eine nur aus einem Azimutwinkel bestehende Strobe-Meldung nicht einfach in die kartesischen Systemkoordinaten transformieren.

Bei Systemen mit mehreren unterschiedlichen Sensoren, aber auch bereits im Mono-Sensor-Fall treten verschiedenartige Zielmeldungen auf, die sich u.a. durch das Vorhandensein oder Nichtvorhandensein bestimmter Meßvektorkomponenten unterscheiden.

Beispiel:     Meldung 1: nur Azimut
               Meldung 2: Azimut und Entfernung
               Meldung 3: Azimut, Elevation und Radialgeschwindigkeit
               Weitere Meldungstypen ergeben sich bei Berücksichtigung der Elevation.

Um diese Signale schaltungstechnisch zu erfassen und zu vermeiden, daß beispielsweise alle diese (oben genannten) Meldetypen in eigenen nur hierfür geeigneten speziellen Prozessoren verarbeitet werden müssen, liegt es nahe, einen einzigen Meldungstyp maximaler Länge in Form eines digital codierten Signales vorzusehen, bei dem lediglich das Vorhandensein oder Nichtvorhandensein der einzelnen Komponenten gekennzeichnet ist, und eine möglichst einheitliche Weiterverarbeitung im Kalman-Filter anzustreben. Mit dem Kalman-Filter in der üblichen Form ist diese Vorgehensweise in nachteiliger Weise nicht möglich, weil bei der statistischen Beschreibung von unvollständigen Meßvektoren, bei denen nur eine oder mehrere Komponenten vorhanden sind, singuläre Meß-Kovarianzmatrizen auftreten.

Aus dem Dokument: 26th IEEE Conference on Decision and Control, Bd. 2, Nr. TP8, 11.Dez. 1987, Los Angeles, US, Seiten 1476 - 1481, HASEMI et al., Parallel structures for Kalman filtering, sind insbesondere für Multi-Sensor-Anwendungen weiterhin verschiedene Anordnungen bekannt, bei denen jedem Sensor ein Kalman-Filter zugeordnet wird. Dabei hat jedes einzelne Kalman-Filter, das auch lokales Filter genannt wird, eine Zustandsdimension, die kleiner ist als diejenige eines Globalfilters, welches den gesamten Zustand eines Zieles verarbeiten kann. Die Ausgangssignale der lokalen Filter werden nun zeitlich parallel an einem zentralen Filter verglichen, um den gesamten, global optimierten Zustand des Zieles zu erzeugen.

Der Erfindung liegt die Aufgabe zugrunde, Ziele zu erfassen, d.h. in Echtzeit die Bahndaten (Position (eventuell einschließlich Höhe), Geschwindigkeitsbetrag und -richtung, eventuell Beschleunigung nach Betrag und Richtung) von Zielen zu bestimmen, welche von einem oder mehreren Sensoren vermessen werden. Die hierzu erforderliche Signalauswerteanordnung soll dabei preiswert und materialsparend herstellbar sein. Desweiteren soll durch sie eine einfache und einheitliche Verarbeitung von unterschiedlichen Zielmeldungs-Typen unter Berücksichtigung der jeweiligen Meßfehler erfolgen.

Diese Aufgabe wird gelöst durch die im kennzeichnenden Teil des Patentanspruchs 1 angegebenen Merkmale. In den Unteransprüchen sind vorteilhafte Aus- und Weiterbildungen beschrieben.

Die Erfindung beruht darauf, daß Signale entsprechend den Komponenten der kinematischen Zustände eines oder mehrerer Ziele abgespeichert und weiterverarbeitet werden. Diese Signale entsprechen beispielsweise den Komponenten Azimut, Elevation, Radialgeschwindigkeit und Entfernung eines Zielobjektes. Aus diesen Signalen wird fortlaufend der Bewegungszustand des Zieles geschätzt und mit einem zeitlich vorhergehenden zugehörigen gespeicherten Bewegungszustand desselben Zieles verglichen. Hierbei ist der Meßraum und das verwendete Koordinatensystem im Gegensatz zum Stand der Technik neu definiert. Des weiteren erfolgt eine komponentenweise Signalverarbeitung.

Im folgenden wird die Erfindung anhand eines Ausführungsbeispieles unter Bezugnahme auf schematisch dargestellte FIG. 1 bis 3 näher erläutert. Es zeigen:

FIG. 1    ein Blockschaltbild zur Erläuterung der Erfindung

FIG. 2    ein weiteres Blockbild zur Erläuterung der Erfindung

FIG. 3    eine Darstellung zur Erläuterung des Zusammenhangs zwischen System- und Meßkoordinaten.

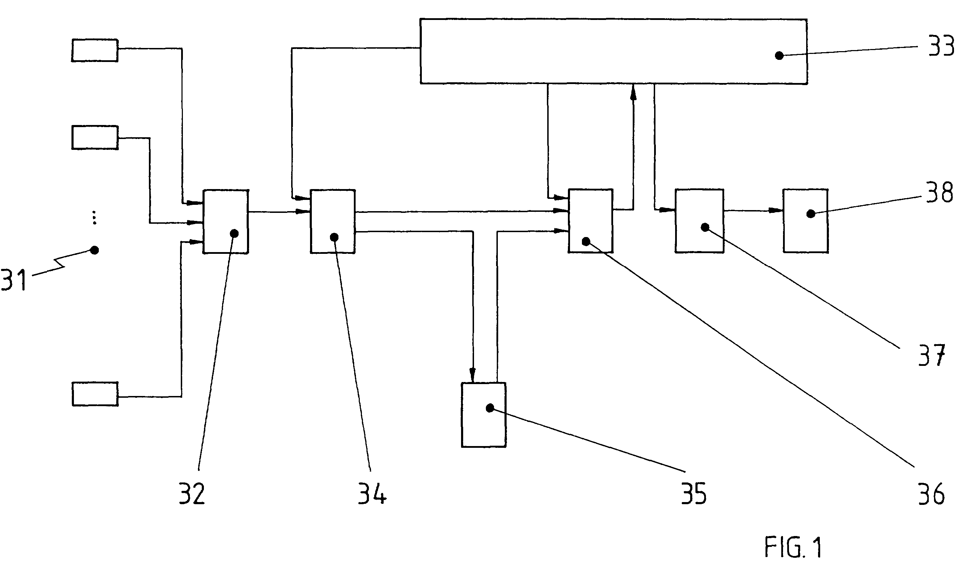

Das Ausführungsbeispiel gemäß FIG. 1 enthält ein Komponentenfilter 36 (auch Track-Filter genannt), das weiter unten durch Regeln beschrieben ist. Es ist beispielsweise in einer Schaltungsanordnung enthalten, die aus der Verschaltung folgender Baugruppen besteht.

Diese Baugruppen bezeichnen, vom Systemeingang her gesehen, eine Sensorengruppe 31, bestehend aus einem oder mehreren Signalwandlern und/oder -aufnehmern, z.B. einer Radaranlage zu Bestimmung von Azimut und Entfernung eines Zieles, eine Zielmeldeeinrichtung 32, die z.B. unter anderem eine Schwellwertbildung bei den von den Sensoren 31 erzeugten Signalen bewirkt und die dann sensorseitig detektierte Signale in Form einer Zielmeldung, z.B. als digitales Codewort und/oder als moduliertes Signal weitergibt.

In einem Trackspeicher 33 werden zu jedem Zeitpunkt die bisher vom System schon erkannten Tracks, welche die kinematischen Zustände eines Zieles als verdichtete Vergangenheitsinformation enthalten, gespeichert. In einer Assoziationseinrichtung 34 werden diejenigen Zielmeldungen aus der Zielmeldeeinrichtung 32 und diejenigen Tracks aus dem Trackspeicher 33 miteinander assoziiert (verglichen), welche vom selben Ziel(objekt) stammen.

In einem Assoziationsspeicher 35 werden diese Assoziationen gespeichert. In dem Komponentenfilter 36 werden Tracks von einem altem Zustand unter Verwendung von assoziierten Zielmeldungen aus dem Assoziationsspeicher 35 in einen neuen Zustand gebracht und in dem Trackspeicher 33 abgespeichert. Die nachgeschaltete Trackmeldeeinrichtung 37 gibt die derart neu gebildeten Tracks an ein oder mehrere Endgeräte 38 weiter, wo sie dargestellt und/oder anderweitig ausgewertet werden.

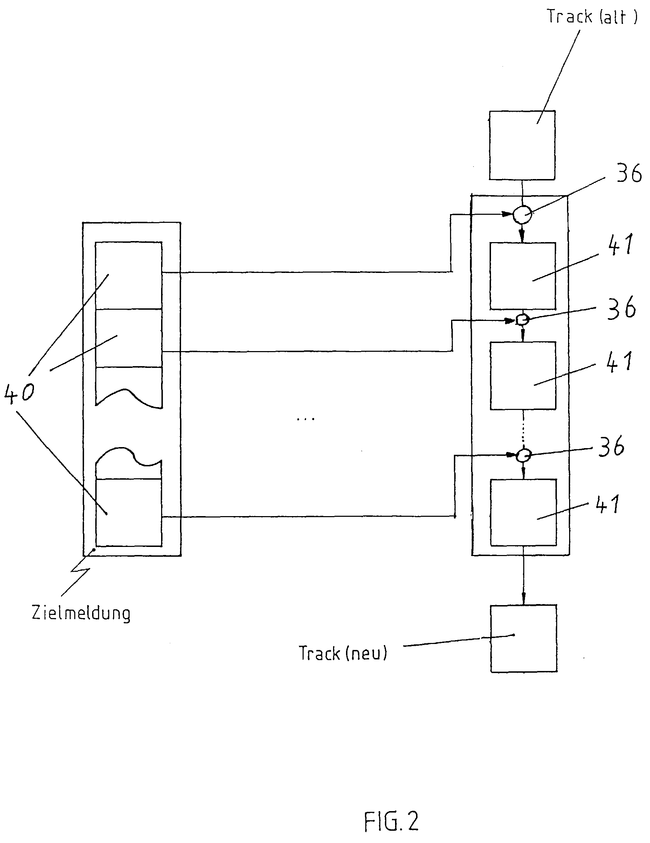

Die prinzipielle Arbeitsweise der Anordnung gemäß Fig.1 ist schematisch in Fig.2 dargestellt. Diese zeigt eine neue, das heißt eine aktuell gemessene (ermittelte) Zielmeldung, die verschiedene Komponenten 40, z.B. Azimut, Entfernung und Geschwindigkeit, enthält. Diese Komponenten 40 werden zeitlich nacheinander Komponentenfiltern 36 zugeführt, die jeweils lediglich nur auf die zugehörige Komponente abgestimmt sind. Die in einem alten Track 41 enthaltenen Zustände werden dann nach dem Durchlaufen eines Komponentenfilters 36 dementsprechend modifiziert. Nach dem Durchlaufen aller Komponentenfilter 36 entsteht ein neuer Track, der abgespeichert und/oder weiterverarbeitet wird.

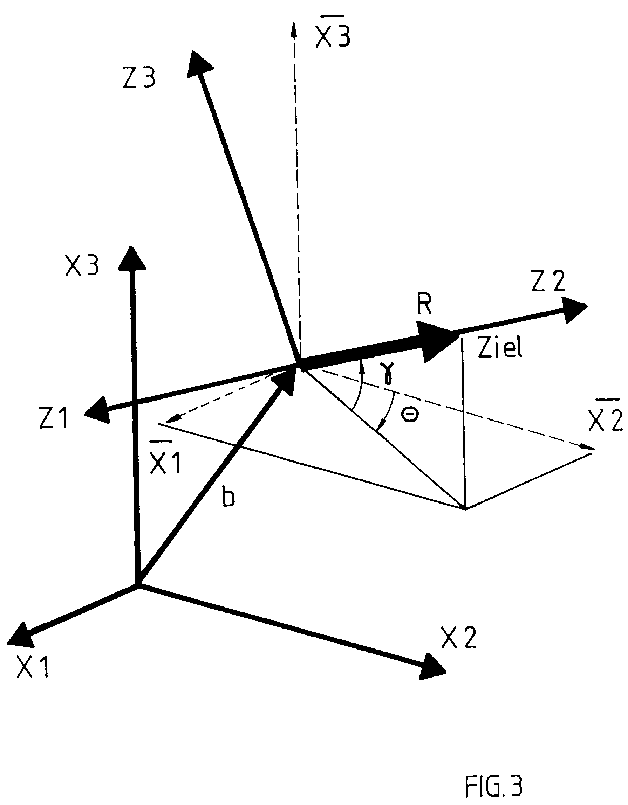

Die Wirkungsweise eines Komponentenfilters 36 wird im folgenden anhand der FIG. 3 erläutert. Diese zeigt ein kartesisches Systemkoordinatensystem X1 bis X3. Von dessen Ursprung führt ein Translationsvektor b zu einem (Meß-)Sensor, der ebenfalls ein kartesisches Koordinatensystem $\bar{x}1$ bis $\bar{x}3$ besitzt. Das Komponentenfilter bewirkt nun, daß die durch $\bar{x}2$ und $\bar{x}3$ aufgespannte Ebene zunächst um den Winkel $\theta$ soweit gedreht wird, daß darin ein Ziel, das durch einen Zielvektor R (Vektor vom Sensor zum Ziel) gekennzeichnet ist, enthalten ist. Anschließend erfolgt eine Kippung des (Sensor-)Koordinatensystems um den Winkel $\gamma$, so daß eine der Achsen Z2 des (Sensor-)Koordinatensystems mit der Richtung des Zielvektors R zusammenfällt. Es entsteht ein in Meßrichtung (Richtung des Zielvektors R) ausgerichtetes Meßkoordinatensystem Z1 bis Z3. Für das Erfassen von Zielen mittels mehrerer räumlich verteilter Sensoren werden als Meßkoordinaten ebenfalls kartesische, ebenfalls in Meßrichtung ausgerichtete Koordinaten verwendet.

Kartesische Meßkoordinaten haben, im Gegensatz zu polaren, den Vorteil, daß die Transformation zwischen System- und Meßraum im wesentlichen durch eine Drehung (Winkel $\theta$ und $\gamma$), also eine lineare Abbildung erreicht wird. Die außerdem erforderliche Translation (Translationsvektor b) von dem System-Nullpunkt zu dem Sensor wird zur Vereinfachung der Erläuterung als nicht fehlerbehaftet und daher im Sinne der Filterung als irrelevant betrachtet. Die Ausrichtung des Meßkoordinatensystems in Meßrichtung hat den Vorteil, daß die statistische Beschreibung der Meßfehler (Meßkovarianz) besonders einfach ausfällt. Auch die Meßvektoren selbst erhalten eine besonders einfache Gestalt. Ein weiterer Vorteil dieser Koordinaten besteht darin, daß sich das Gating, d.h. die Bestimmung des statistischen Abstandes zwischen einem Track und einer Zielmeldung, einfach gestaltet. Bei dieser Abstandsbestimmung wird der geometrische Abstand mit der Inversen der Innovations-Kovarianz-Matrix skaliert. Die Matrix-Invertierung wird besonders einfach, weil im eingeschwungenen Zustand, wenn die Innovation im wesentlichen durch die Meßfehler bestimmt ist, die Innovations-Matrix annähernd Diagonalgestalt hat. Der Begriff Innovation bezeichnet die (vektorielle) Abweichung einer tatsächlichen Messung von der (gespeicherten) Meßvorhersage eines Tracks. Durch das Gating werden die (Zustands-)Grenzen festgelegt, innerhalb denen sich die zu einem bestimmten Ziel gehörige Innovation bewegen darf. Eine Innovation, die außerhalb dieser (Zustands-)Grenzen liegt, wird als zu einem anderen Ziel gehörig betrachtet.

In dem Komponentenfilter 36 werden nach FIG. 2 alle Signale (auch Komponenten oder Teilmessung genannt) separat, das heißt unabhängig voneinander, verarbeitet. Hierbei sind die Komponenten (z.B. Azimut, Elevation, Entfernung, Radialgeschwindigkeit usw.) als statistisch unabhängig auffaßbar.

Bei der komponentenweisen Verarbeitung der Filterungs-Ergebnisse ergeben sich für die Realisierung erhebliche Vorteile zugunsten des Komponentenfilters. Es reicht aus, ein Filter für jede im System vorkommende Teilmessung, z.B. Azimut, Entfernung, Elevation, Radialgeschwindigkeit (auch Tangentialgeschwindigkeit und Vertikalgeschwindigkeit und/oder Beschleunigungen können, falls gemessen, verarbeitet werden), vorzusehen. Je nach Anzahl und Art der in einem Meßvektor vorhandenen Teilmessungen werden einzelnen Teilfilter entweder durchlaufen oder übersprungen. Der in den Teilfiltern zu treibende Aufwand ist gering im Vergleich zu einem Filter für die Verarbeitung des gesamten Meßvektors in einem einzigen Schritt. Da ungeachtet der Komplexität des Gesamtsystems das Komponentenfilter sich aus wenigen einfachen, voneinander unabhängigen Teilfunktionen aufbauen läßt, wobei auch noch für die meisten die Abarbeitungsreihenfolge beliebig wählbar ist (gemeint sind die einzelnen Trakkerneuerungsschritte mit den verschiedenen Teilmessungen), läßt sich der Konflikt zwischen hohen Lastzahlen (typisch sind hunderte von Zielen und viele Sensoren mit hohen Signalraten) einerseits und begrenzter Rechenleistung eines einzelnen Prozessors andererseits auflösen, in dem für die einzelnen Teilfunktionen jeweils eigene Prozessoren verwendet werden.

Der Meßraum ist so dimensionierbar, daß die bisher beschriebenen Spezialisierungen sich auf zwei Wegen realisieren lassen:

Bei konsequenter Fortführung des Gedankens der komponentenweisen Meßvektorverarbeitung bietet es sich an, jede Teilmessung in einem eigenen eindimensionalen Mepraum (z.B. nur der Entfernung), der ein Teilraum des oben beschriebenen, in Meßrichtung orientierten Meß-Koordinaten-Systems ist, zu beschreiben. Dann besteht die zugehörige Meßmatrix H, welche den Übergang von System- zu Meßkoordinaten beschreibt, aus nur einer Zeile, die Messung selbst ist ein skalarer Wert und zu ihrer statistischen Beschreibung genügt ein einziger Varianzwert.

Der zweite Weg ist die Verwendung des mehrdimensionalen Raumes, welcher durch die Gesamtheit aller im System möglichen Teilmeldungen aufgespannt wird, als Meßraum. Dabei ergeben sich als Vorteile besonders einfache Erfassungs-(Track-) Initiierungs- und Gating-Prozeduren.

Arbeitet man mit einem mehrdimensionalen Meßraum, so entsteht bei der Beschreibung von Teilmessungen die Schwierigkeit, daß die Meßfehler-Kovarianz-Matrizen singulär werden. Zu den in einer Teilmessung nicht verwendeten Komponenten (z.B. Entfernungskomponente bei einer Azimut-Teilmessung) gehören unendliche Werte in der Kovarianz-Matrix. Daher wird das Komponentenfilter 36 vorteilhafterweise so ausgebildet, daß statt der Meßfehler-Kovarianz-Matrizen deren Inverse auftreten. Mithin ist das Komponentenfilter 36 durch folgende Regeln dargestellt (wobei die Nomenklatur gemäß derjenigen des Standes der Technik gewählt ist).

$$x_k^+ = x_k^- + K_k \cdot (Z_k - H_k \cdot x_k^-) \qquad (2.0)$$

mit

$$K_k = P_k^+ \cdot H_k^T \cdot R_k^{-1} \qquad (2.10)$$

$$P_k^- = \phi_k \cdot P_{k-1}^+ \cdot \phi_k^T + G_k \cdot W_k \cdot G_k^T \qquad (2.11)$$

$$P_k^+ = P_k^- \cdot H_k^T + (I + R_k^{-1} \cdot H_k \cdot P_k^- \cdot H_k^T)^{-1} \cdot H_k$$

$$(2.12)$$

$$P_o^+ = P_o \qquad (2.13)$$

$$x_o^+ = \mu_o \qquad (2.20)$$

$$x_k^- = \phi_k \cdot x_{k-1}^+ \qquad (2.21)$$

wobei

$$Z_k = H_k \cdot \hat{x}_k + v_k \qquad (2.30)$$

$$\hat{x}_k = \phi_k \cdot \hat{x}_{k-1} + G_k \cdot u_k \qquad (2.31)$$

und

$$E\{u_k\} = 0,\ E\{v_k\} = 0,\ E\{\hat{x}_o\} = \mu_o \qquad (1.40)$$

$$\text{cov}\{u_j, u_k\} = W_j \cdot \delta_K\,(j-k) \qquad (1.41)$$

$$\text{cov}\{v_j, v_k\} = R_j \cdot \delta_K\,(j-k) \qquad (1.42)$$

$$\text{cov}\{u_j, v_k\} = \text{cov}\{\hat{x}_o, u_k\} = 0 \qquad (1.43)$$

$$\text{cov}\{\hat{x}_o, v_k\} = 0 \qquad (1.44)$$

$$\text{var}\{\hat{x}_o\} = P_o \qquad (1.45)$$

Der Erfassungs-Zustandsraum wird durch kartesische Koordinaten beschrieben. Angepaßt an die System-Erfordernisse und die integrierten Sensoren kann die Dimensionierung des Zustandsraumes verschieden ausfallen. Der Zielort kann durch zwei oder drei Komponenten beschrieben werden, außer den ersten Zeit-Ableitungen der Ortskomponenten können unter geeigneten Bedingungen auch die zweiten Zeit-Ableitungen der Ortskomponenten im Zustand verwendet werden.

Durch eine Ausbildung des Komponentenfilters 36 gemäß den obigen Regeln ist zeit- und materialsparend ein Filter realisierbar für Mono- und Multi-Sensor-Systeme. Es ist eine optimale Verarbeitung unterschiedlicher Zielmeldungen (z.B. 2D-Radar, 3D-Radar, Radialgeschwindigkeit, Strobes) möglich, ohne daß jeweils ein eigener Signalzweig für jeden der Sensoren verwendet wird. Des weiteren werden durch die Ausbildung der Erfindung gemäß obiger Beschreibung die bereits oben genannten Vorteile erreicht.

**Patentansprüche**

1. Kalman-Filter für die Ermittlung einer Spur (Track) eines Zieles, wobei

   - die von mindestens einem Sensor zur Verfolgung des Zieles ermittelten aktuellen Zielmeldungen (Meßvektoren) einem zentralen Filter zugeleitet werden,

   - in dem zentralen Filter die aktuellen Zielmeldungen mit bekannten Zielmeldungen verglichen werden und daraus die Spur bestimmt wird,

   - die Zielmeldung mindestens eine Komponente enthält, welche einen kinematischen Zustand des Zieles beschreibt,

   - in einem Signalfluß für die Ermittlung der Spur mindestens ein Komponentenfilter (36) vorhanden ist, in dem durch Verarbeitung lediglich einer vorgebbaren Komponente der Zielmeldung eine Änderung (Modifizierung) der Spur nach vorgebbaren Maßgaben entsprechend der Komponente erfolgt,

   - bei einer mehrere unterschiedliche Komponenten enthaltenden Zielmeldung in dem Signalfluß zu jeder Komponente ein auf diese abgestimmtes vorgebbares Komponentenfilter (36) vorhanden ist,

   - bei einer Zielmeldung, die mehrere Komponenten enthält, in den zu den Komponenten gehörenden Komponentenfiltern (36) eine voneinander unabhängige Verarbeitung der Komponenten erfolgt,

   dadurch gekennzeichnet,

   - daß die Zielmeldung sowie die Komponente in einem kartesischen Koordinatensystems beschrieben sind,

   - daß den statistischen Fehlern der Komponenten die Inversen der Fehlervarianzen zugeordnet sind, und

   - daß bei einer Zielmeldung mit mehreren Komponenten, diese in dem Signalfluß zeitlich nacheinander verarbeitet werden, wobei in dem Signalfluß möglicherweise vorhandene weitere Komponentenfilter, die in der Zielmeldung nicht vorhandenen Komponenten zugeordnet sind, übersprungen werden.

2. Kalman-Filter nach Anspruch 1, dadurch gekennzeichnet, daß mindestens ein Komponentenfilter (36) zur Verarbeitung von Zielmeldungen in einem messungsspezifischen kartesischen Koordinatensystem vorhanden ist, bei dem

   - Systemkoordinaten (X1 bis X3) als kartesische Koordinaten und

   - sensorspezifische Koordinaten (Z1 bis Z3) als kartesische Koordinaten, bei denen eine Koordinatenachse (Z2) mit der auf den Sensor bezogenen Zielrichtung (R) zusammenfällt, ausgebildet sind.

**Claims**

1. Kalman filter for the ascertaining of a track of a target, wherein

- the actual target reports (measurement vectors) ascertained by at least one sensor for the tracking of the target are conducted to a central filter,
- the actual target reports are compared in the central filter with known target reports and the track is determined therefrom,
- the target report contains at least one component which describes a kinematic state of the target,
- at least one component filter (36), in which by processing merely one presettable component of the target report a modification of the track in accordance with presettable measures appropriate to the component is carried out, is present in a signal path for the ascertaining of the track,
- in the case of a target report containing several different components a presettable component filter (36) is present in the signal path to each component and is tuned to this,
- in the case of a target report which contains several components a mutually independent processing of the components is carried out in the component filters (36) belonging to the components,

characterised thereby

- that the target report as well as the component are described in a cartesian co-ordinate system,
- that the inverses of the error variances are associated with the static errors of the components, and
- that in the case of a target report with several components these are processed in the signal path one after the other in time, wherein further component filters which are possibly present in the signal path and with which components not present in the target report are associated, are passed over.

2. Kalman filter according to claim 1, characterised thereby that at least one component filter (36) for the processing of target reports in a cartesian co-ordinate system specific to measurement is present, in which

- system co-ordinates (X1 to X3) are formed as cartesian co-ordinates and
- co-ordinates (Z1 to Z3) specific to sensor are formed as cartesian co-ordinates in which a co-ordinate axis (Z2) coincides with the target direction (R) referred to the sensor.

**Revendications**

1. Filtre de Kalman pour la détermination d'une trace (track) d'une cible,

- les signalisations de cible (vecteurs de mesure) actuelles, déterminées par au moins un capteur pour la poursuite de la cible, étant conduites à un filtre central,
- dans le filtre central, les signalisations de cible actuelles étant comparées avec des signalisations de cible connues, et, à partir de cela, la trace étant définie,
- la signalisation de cible contenant au moins une composante, laquelle décrit un état cinématique de la cible,
- dans un flux de signal pour la détermination de la trace, au moins un filtre de composante (36) étant présent, dans lequel, par traitement simplement d'une composante susceptible d'être préallouée de la signalisation de cible, un changement (modification) de la trace a lieu selon des mesures susceptibles d'être allouées correspondant à la composante,
- lors d'une signalisation de cible contenant plusieurs composantes différentes, dans le flux de signal, à chaque composante, un filtre de composante (36) susceptible d'être préalloué, accordé sur celle-ci, étant présent,
- lors d'une signalisation de cible, qui contient plusieurs composantes, dans les filtres de composante (36) appartenant aux composantes, des traitements des composantes indépendants les uns des autres ayant lieu,

    caractérisé en ce,

- que la signalisation de cible, ainsi que les composantes, sont décrites dans un système de coordonnées cartésien,
- qu'aux défauts statistiques des composantes sont associés les inverses des variances de défaut, et
- que, lors d'une signalisation de cible avec plusieurs composantes, celles-ci seront traitées l'une après l'autre dans le temps dans le flux de signal, d'autres filtres de composante, pouvant être présents dans le flux de signal, qui, dans la signalisation de cible, ne sont pas associés à des composantes présentes, étant sautés.

2. Filtre de Kalman selon la revendication 1, caractérisé en ce qu'au moins un filtre de composante (36) pour le traitement de signalisations de cible est présent dans un système de coordonnées cartésien spécifique de mesure, lors duquel

- des coordonnées de système (X1 à X3) sont constituées comme des coordonnées cartésiennes, et

- des coordonnées (Z1 à Z3) spécifiques de capteur sont constituées comme des coordonnées cartésiennes, lors desquelles, un axe de coordonnées (Z2) coïncide avec la direction de cible (R) rapportée sur le capteur.

FIG. 1

EP 0 452 797 B1

FIG. 2

FIG. 3